# EUROPEAN PATENT SPECIFICATION

(11) **EP 3 941 870 B1**
(45) Date of publication and mention of the grant of the patent: **09.04.2025**
(21) Application number: 20704945.3
(22) Date of filing: 30.01.2020
(51) Int. Cl.: B66B 1/34, G01D 5/14

(54) **SYSTEM FOR MEASURING THE POSITIONING OF AN OBJECT RELATIVE TO A FIXED REFERENCE**
SYSTEM ZUR MESSUNG DER POSITIONIERUNG EINES OBJEKTS IN BEZUG AUF EINEN FESTEN REFERENZ
SYSTÈME DE MESURE DU POSITIONNEMENT D'UN OBJET PAR RAPPORT À UNE RÉFÉRENCE FIXE

(30) Priority: 20.03.2019 IT 201900004071
(43) Date of publication of application: 26.01.2022
(73) Proprietor: Stem S.r.l., 27010 Cura Carpignano (Pavia) (IT)
(72) Inventor: BAGNALASTA, Nicola, 27017 Zerbo (PV) (IT); MORO, Fabio, 27010 Cura Carpignano (PV) (IT); MORO, Simone, 27050 Torricella Verzate (PV) (IT)
(74) Representative: Giugni, Diego
(86) International application number: PCT/IB2020/050730
(87) International publication number: WO 2020/188367

(56) References cited:
- EP-A1- 2 567 923
- WO-A1-86/07041
- GB-A- 2 183 044
- JP-A- 2004 142 858
- US-A1- 2011 147 135
- US-B1- 6 578 437
- US-B2- 7 857 106

## Description

### TECHNICAL FIELD OF THE INVENTION

The present invention refers to a system for measuring the positioning of an object with respect to a fixed reference and, in particular, to a system for measuring along a rectilinear wire rope or cable. The invention also refers to a lift or elevator comprising said measuring system.

### STATE OF THE PRIOR ART

Automatic measurements of the positioning of an object with respect to a fixed reference may be made with numerous systems and devices that have been widely known for many years. The systems most commonly used for this purpose comprise the use of linear or rotary encoders. In particular, rotary encoders convert the angular position of their rotation shaft into a digital electrical signal. By means of mechanical connections between said rotation shaft and an optical reader, the encoder is able to measure angular displacements, rectilinear and circular movements, as well as rotation speeds and accelerations.

Absolute or incremental rotary encoders present on the market in general are actuated through three different mechanisms: extension and withdrawal of a wire connected on one end to the inner parts of the encoder and on the other end to the object having the linear displacement to be measured; a pin coupled in a suitable seat created within the object having the rotation to be measured; a cavity within which a pin of the object having the rotation to be measured is inserted.

All the aforesaid devices have in common the characteristic of being fixed and motionless because they work by means of the displacement or rotation of an external object. Thus, that which allows the measurement is the rotation of the inner parts of the encoders through the motion transmitted by external objects that are in motion.

Systems such as those just described are widely used as they generally allow reading accuracy and reliability over time.

It should be noted, however, that in specific applications, for example on lifts or elevators, these types of encoders are not used because the transmission of the movement via pin or cable are indirect measurements that may be carried out on the motor of the lift but may lack correlation with the actual movement of the cab; one should consider, for example, the possible slippage of the wire ropes on the motor. Whereas wire encoders are not usable for long distances (e.g. 100m) as the size would become excessive and there would still be a problem of wire tensioning.

In effect, for example, for the aforesaid application of lifts or elevators, there are position measuring systems in a well wherein the detecting device is connected to the cab because this ensures greater accuracy than other methods that are generally not favored for the reasons listed above.

There are basically five devices available to date.

The first consists of magnetic sensors placed on the roof of the cab in order to detect the presence of magnets placed on the rails or elements associated thereto. This system, which is still the most economical to date, does not, however, provide a continuous and absolute position (in the case of a large number of floors) of the cab.

The second is made up of magnetic or optical encoders that exploit the detection of multiple tracks of magnets or holes on a flexible band. The optical elements are placed horizontally as are the various tracks and are therefore perpendicular to the direction of movement. These systems do not guarantee the detection of a continuous and absolute position of the cab but only at the point wherein the magnets or holes are present.

The third uses ultrasounds that are carried by a wire that must be extended from the top to the bottom of the well of travel. The signal intercepts the target, which is integral with the cab and which is ring-shaped within which the wire passes. The position of the cab is determined based on the flight time of the signal from its emitter located at one end of the wire to the target and back to a receiver that is integrated in the device. This system provides the absolute position of the cab at all times. Nevertheless, it is an expensive and complex system to install, because if the wire were to be bent or not perfectly intact the signal could not pass and provide the correct information.

The fourth uses magnetic encoders based on a multitude of Hall effect or magnetoresistive chips that read a magnetic band with a sequence of NORTH and SOUTH polarity. The magnetic strip is supported by a metal plate which guarantees its integrity which would be compromised by its weight. In effect, also in this case the strip (magnetic part plus support) is spread along the entire length of the lift well while the encoder is integral with the cab. The strip must slide very close to the wall where the Hall or magnetoresistive chips are positioned, and for this reason it must pass within a compartment created within the encoder. The system is very efficient but very expensive.

The fifth is an optical encoder that is based on the detection of a metallic strip that has several tracks thereon. The metal strip is extended along the entire length of the lift well, while the optical encoder is integral with the cab. Also in this case the strip must slide within the encoder. This system may easily be affected by dirt, dust or smoke present in the well.

WO86/07041 discloses a screw lift comprising a lift car movably supported along an upright fixed screw and carrying a nut in engagement with said screw, and drive means including at least one electric motor for rotation of the nut on the screw and thereby driving of the lift car along the screw. A pulse transmitter by sensing and/or determining the position of the nut on the screw is arranged.

### SUMMARY OF THE INVENTION

The technical problem underlying the present invention is therefore that of providing a system for measuring the positioning of an object with respect to a fixed reference that is able to function effectively for any type of specific application, i.e. it is highly versatile, while maintaining the features of precision and reliability of the known systems.

This problem is solved by a system for measuring the positioning of an object with respect to a fixed reference comprising a rotary encoder sliding on said fixed support.

A first subject-matter of the invention is therefore a lift or elevator according to claim 1.

An additional subject-matter is a method for detecting the position of a lift or elevator by means of a measuring method.

### BRIEF DESCRIPTION OF THE FIGURES

Further features and advantages of the measuring system of the invention will become more apparent from the following description of some embodiments provided purely by way of non-limiting example with reference to the following figures, wherein:
- Figure 1 represents a schematic axonometric view of a toothed nut of the measuring system of the invention;
- Figure 2 is a cross-section along the line II-II of Figure 1 ;
- Figure 3 represents a schematic axonometric view of the nut of Figure 1 mounted on a wire rope by means of retaining bearings;
- Figure 4 is a cross-section along the line IV-IV of Figure 3;
- Figure 5 is a schematic axonometric view of the nut of Figure 3 associated with a system of gears and the measurement sensors thereof, in accordance with a first embodiment being not part of the invention;
- Figure 6 is a schematic axonometric view of the nut of Figure 3 associated with a reductive epicyclical system and the measurement sensors thereof, in accordance with a second embodiment being not part of the invention;
- Figure 7 is a schematic axonometric view of the nut of Figure 3 associated with a reductive epicyclical system with a ring magnet mounted on the nut, in accordance with the invention;
- Figure 8 is a schematic view of an example of application of the measuring system of the invention.

### DETAILED DESCRIPTION OF THE INVENTION

Given the limited versatility of known encoders and the complexity, cost and limited reliability of measuring systems in specific applications, the idea behind the present invention was to create a structurally simple measuring system that relies on encoders to be easily applicable to any machine, even in environments that are difficult to access.

It was thought, therefore, to find a system wherein the encoder would be applied to the object having the position to be detected, but which would not require supports or references for the measurement, which are cumbersome, delicate and therefore require special maintenance.

After numerous attempts, a structure associated with a conventional rotary encoder was designed to allow the measurement of the positioning by means of its translation along a fixed element that at the same time functions as a reference for the measurement itself.

In practice, the fixed element consists of a rectilinear element having an continuous helical surface or a worm on which the encoder may be slidably mounted. In particular, the encoder is operatively associated with said fixed element by means of a sleeve nut having thus a surface complementary to the helical surface of the same element in order to allow it to slide along said element. In turn, the sleeve comprises mechanical and/or magnetic means adapted to excite corresponding means of detection of said encoder.

In accordance with a first embodiment of the invention, the sleeve comprises a circumferential toothed ring to engage with a toothed wheel of the encoder. In other words, the toothed ring of the sleeve is adapted to transmit the rotary motion to subsequent toothed elements of different sizes connected thereto. These elements may in turn be connected to other elements having the same geometry but different dimensions that allow the desired length to be measured, as explained hereinafter. Moreover, the relationship between the geometries of these elements allows for different angular rotations that allow an absolute measurement.

As a result, the system for measuring the positioning of a lift or elevator according to the invention comprising an encoder mounted on said object and a fixed, rectilinear reference element, wherein said fixed and substantially rectilinear element comprises an external helical or threaded cylindrical surface, and said encoder is preferably a rotary encoder associated with said fixed and substantially rectilinear element by means of a sleeve having an internal surface complementary to said helical or threaded surface so as to allow it to slide along said element, and a circumferential toothed ring for engagement with a toothed wheel of said encoder.

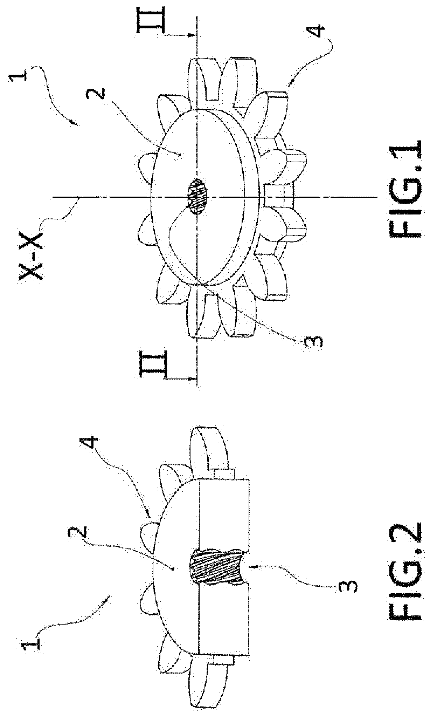

Figure 1 shows a sleeve 1 comprising a central body 2 preferably in the form of a disk and penetrated along its axis X-X of rotation by a circular hole 3. The hole 3 advantageously has a wall with helical grooves or threads, which, as explained hereinafter, will be coupled with complementary grooves of the reference fixed element. The sleeve 1 also comprises a circumferential toothed ring 4, which extends from said body 2 to transmit the circular motion thereof to a toothed wheel of the encoder, conventional per se.

In Figure 2, the section orthogonal to the disk-shaped body highlights the particular wall of the hole 3 with helical-shaped grooves.

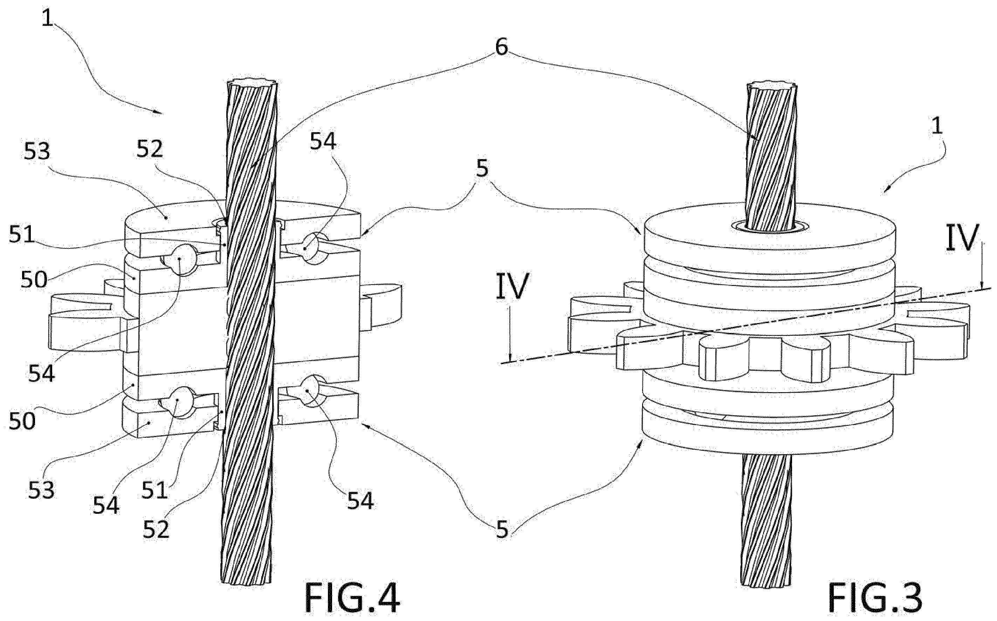

With reference to Figures 3 and 4, the sleeve 1 preferably comprises a pair of retaining bearings 5 fixed on each of the opposing faces of the disk-shaped central body 1. In particular, as better shown in the section of Figure 4, the bearings comprise a first disk element 50 provided with a central portion 51 with a bushing having a hole 52 which is smooth and of a diameter slightly larger than that of the fixed element, and a second disk element 53 to enclose a plurality of balls (not shown) in corresponding seats 54 obtained on both said first and second disk elements.

The advantage of using said pair of bearings is that it allows the central body 2 to rotate freely and with as little friction as possible as the encoder travels along the reference fixed element 6. In particular, the second disk elements 53 remain fixed, i.e. they do not rotate, and manage the translation thrust by switching it to a rotation of the first disk elements 50 via the balls. Therefore, the first elements 50 are connected integrally to the central body 2 or may be made in one piece therewith. In addition, with this structure the orthogonal position of the sleeve 1 with respect to the reference fixed element is ensured. In effect, since the engagement between the hole 3 of the body 2 of the sleeve with the fixed element takes place in rotation and with a certain mechanical clearance, misalignments could occur during sliding. Due to the presence of said bearings, this drawback is avoided.

The sleeve 1 is therefore slidably associated with a reference fixed element 6 (Figures 3-7) provided with a circular outer surface with helical grooves complementary to those of the hole 3 in the body 2. In particular, the reference fixed element 6 is an entirely conventional wire rope of which the pitch of the wires stranded together may be selected at will or according to specific requirements that also take into account the distances to be measured.

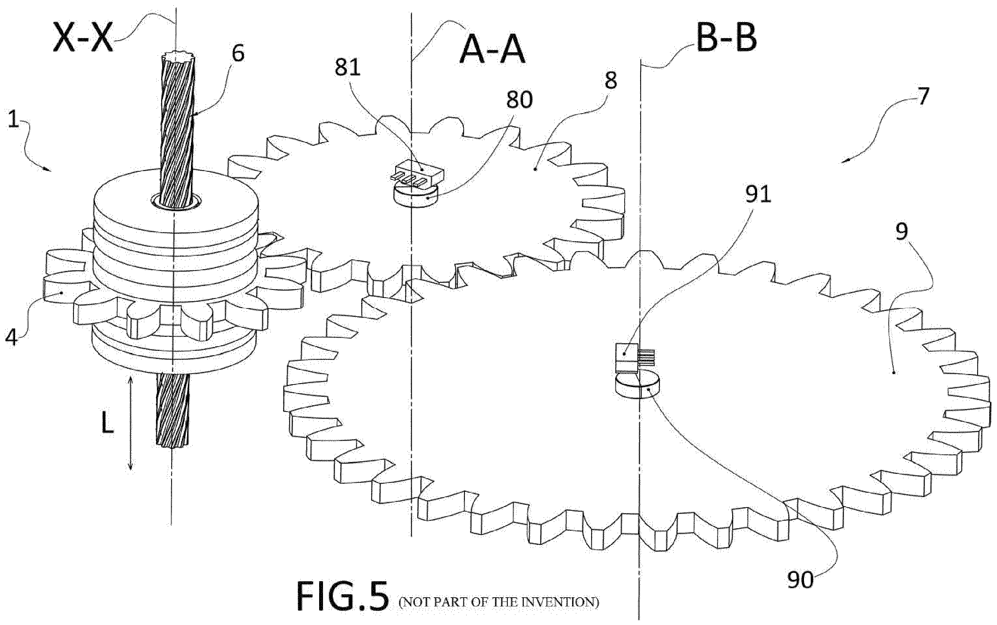

With reference to Figure 5, the sleeve 1 is applied to a first embodiment being not part of the measuring system of the invention, but its description being useful to understand the following description of the invention. In particular, the measuring system comprises the sleeve 1 mounted slidably on the rope 6 and a rotary encoder 7. The sleeve and the rope are those described above, while the rotary encoder 7 is schematically represented by a pair of toothed wheels with relative sensors.

The first toothed wheel 8 engages simultaneously with the circumferential toothed ring 4 of the sleeve 1 and the teeth of the second toothed wheel 9. The measurement of the displacement may be carried out by the rotation of said wheels with different dimensions (which therefore create a reduction of the revolutions). The accuracy of the displacement measurement, as well as the number of wheels necessary, may be influenced by the geometry of the helix of the rope; in particular, the more it is contracted (i.e. the coils of the wire rope are closer together) the higher the accuracy, however more wheels are necessary to carry out a coding over long distances; the more it is extended (i.e. the coils of the rope are further away), the lower the accuracy, however fewer wheels are required to carry out a coding over long distances.

The wheels may take advantage of the technologies already known in encoders on the market, i.e. generally slits of different sizes for optical systems, or they may contain magnets with two-pole radial polarization to which are associated as many electronic magnetic sensors adapted to measure the variation of the magnetic field on a single revolution. This latter configuration may have a resolution of one degree and therefore provide a coding of 360 values per single revolution of the wheel. This high density of values for each revolution may allow a very extensive coding even with a limited number of wheels determined by the reduction ratio of the various gears.

For example, as shown in Figure 5, on each axis of rotation of the first wheel 8 and the second wheel 9, respectively A-A and B-B, a bipolar magnet 80, 90 and a corresponding sensor 81, 91 are mounted. In order to have a complete rotation of the first wheel, several rotations of the sleeve will be necessary. The sensor 81 on the first wheel 8 will provide different signals at each angle of rotation making the measurement absolute on the single revolution of the first wheel to which it is applied. The same logic applies to the second toothed wheel 9 which will complete a full rotation after the first wheel 8 has completed a number of rotations equal to the teeth ratio of the first and second wheels. Preferably, the sensors are of the Hall effect type and read the rotation of radially polarized magnets.

Now, assuming that a complete revolution of the sleeve 1 corresponds to the measurement of a distance L, for example, with two sensors of a certain resolution, an absolute distance of L × K may be measured where K is the ratio between the teeth of the toothed wheels. The greater the resolution of the sensor, the greater the ratio K that could be used. Considering a magnetic sensor with a resolution of 1°, K could be equal to 360.

In a measuring system requiring a positioning accuracy of 1 mm, the sleeve could complete a full revolution following a linear displacement of 360 mm of the object to be monitored. Therefore, with two wheels a theoretical measuring distance of L×K=360mm×360mm=129.6m could be achieved.

If a displacement of 100m is to be measured, using a rope 6 with a helix having a pitch P of 50 mm (linear distance equivalent to one full rotation) and toothed wheel with Kmax of 360, at least two toothed wheels would be required. Thus, in this case, the resolution of the measuring system will be 50mm/360=0.13mm.

With the aforesaid two toothed wheel configuration, a first 8 and a second 9, the total measurable distance is thus in general L×K1×K2, where L is the linear distance corresponding to a full rotation of the sleeve, K1 is the ratio between the first toothed wheel 8 and the circumferential toothed ring 4 of the sleeve 1, and K2 is the ratio between the second toothed wheel 9 and the first toothed wheel 8. This approach is obviously replicable for a number of toothed wheels necessary to cover the entire length that is to be measured.

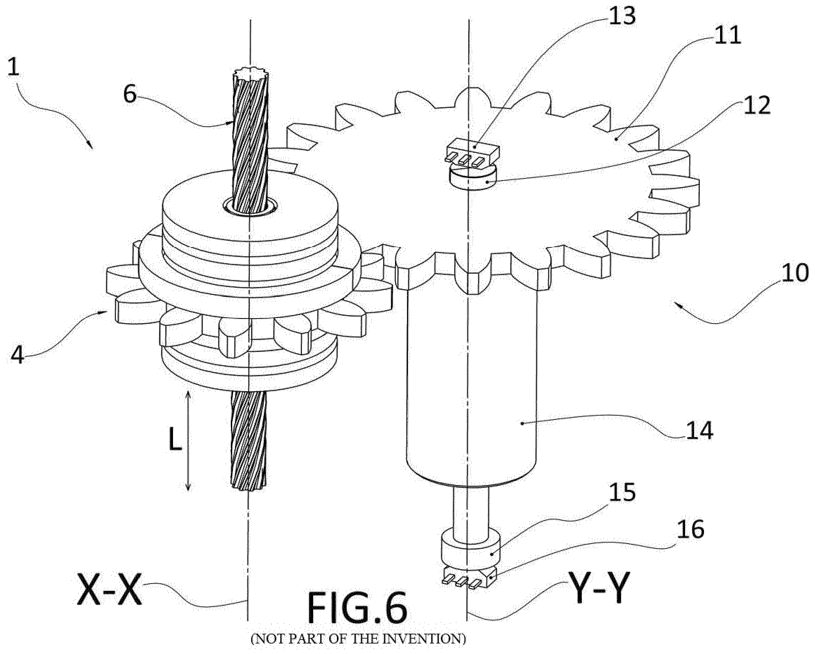

With reference to Figure 6, a second embodiment being not part of the invention, but its description being useful to understand the following description of the invention, is shown wherein the measuring system comprises a sleeve 1 mounted slidably on a rope 6 and a rotary encoder 10. The sleeve and rope are identical to those described above and will thus not be explained further. The encoder 10 comprises a toothed wheel 11 that engages with the circumferential toothed ring 4 of the sleeve 1. A magnet 12 and a corresponding sensor 13, identical to those described above, are mounted on one side of said toothed wheel on the axis of rotation Y-Y. On the opposite side of the wheel, a reductive epicyclical system 14 is axially mounted and thereon, again axially, a corresponding magnet 15 and a corresponding sensor 16 of the same type as the previous magnets and sensors.

In particular, with the epicyclical system 14 it is possible to have high multiplication ratios between the number of revolutions of the toothed wheel 11 and the epicycles. The resolution of the measuring system in this case is L×K1/P, where L is the distance traveled by the sleeve 1 in a complete revolution, K1 is the ratio between the circumferential toothed ring 4 of the sleeve and the toothed wheel 11 and P is the number of steps detectable on the single revolution by the electronic sensor 13 of the magnet 12. The maximum measurable length, on the other hand, is determined by the type of helix of the fixed element or wire rope 6, by the number of moving elements in rotation that make up the measuring system (circumferential toothed ring of the sleeve, toothed wheels, epicycles) and by the multiplication ratio between them.

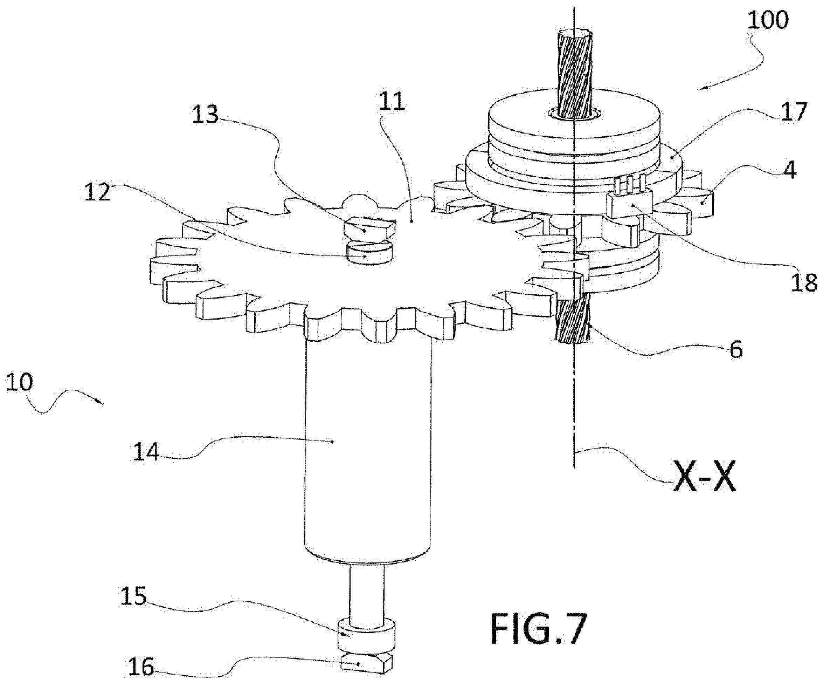

In accordance with a third embodiment being part of the invention, as shown in Figure 7, it is possible to reduce the number of toothed wheels or epicycles and increase the resolution of the measuring system by means of a bipolar ring magnet 17 mounted directly on a sleeve 100 and to associate an angular sensor, e.g. a Hall effect sensor, therewith. In particular, the measuring system comprises a sleeve 100 mounted slidably on the reference fixed element or wire rope 6 and a rotary encoder 10. The wire rope and encoders are identical to those described with reference to the second embodiment of the invention and will not be further described here. The sleeve 100 is provided with a structure generally identical to that of the sleeve 1 explained above, with the same elements and the same shapes that have been represented in the figure at the same reference numbers. In particular, the sleeve 100 differs from the previous one because it comprises the aforesaid bipolar ring magnet 17 equipped with a corresponding sensor 18.

In accordance with a further embodiment, the measuring system may be incremental. In this case, the sleeve comprises a central body equipped with a multipole radial magnetic ring, without a circumferential toothed ring. A Hall effect sensor is then mounted on the encoder to read the change in magnetic fields caused by the rotation of the ring. This structure is constructively simpler with respect to those described above.

According to a still further variant being not part of the invention, the measuring system may comprise an optical sensing encoder wherein the angular position is detected by means of optical systems that read appropriate windows or holes obtained in its wheels, in a completely conventional way. The incremental or absolute version of the encoder may also be achieved using this technology.

In accordance with a second subject-matter being not part of the invention, a method for measuring the positioning of an object with respect to a reference fixed element comprises the steps of:
- providing a reference cylindrical fixed element, rectilinear and rigid, provided with a helical or threaded outer surface;
- providing an encoder operatively connected to said fixed element by means of a sleeve having an inner helical or threaded surface complementary to the helical surface of said element;
- mounting said rotary encoder onto said reference element by coupling of the inner helical surface of the sleeve with the outer helical surface of said element;
- fixing said encoder carrying said fixed reference element to an object of which the position is to be measured;
- moving the object so that the encoder slides along said element;
- detecting the position of the object with respect to said reference fixed element through said encoder.

In particular, said step of detecting the position of the object is carried out by causing mechanical or magnetic inputs produced by the rotation of said sleeve, inputs detected by said encoder as angular positions and transformed into linear measurements.

Moreover, said inputs are detected through mechanical means such as toothed wheels, magnetic means or optical means, as explained above.

The steps of providing the reference fixed element and the encoder are preferably carried out by providing these devices in the form described above.

In addition, the step of detecting the position of the object is carried out by a program loaded on a microprocessor of the encoder able to transform the rotary movement transmitted by the circumferential toothed ring of the sleeve and demultiplied by the toothed wheel or toothed wheel system into linear measurement. In practice, the magnetic sensors described above are activated whenever they detect the rotation of one or more wheels and send to the microprocessor corresponding electrical signals converted into numerical values reprocessed according to the aforesaid formulas in order to provide the desired measurement.

A further subject-matter of the invention is a particular application of the measuring system described above in the field of lifts or elevators.

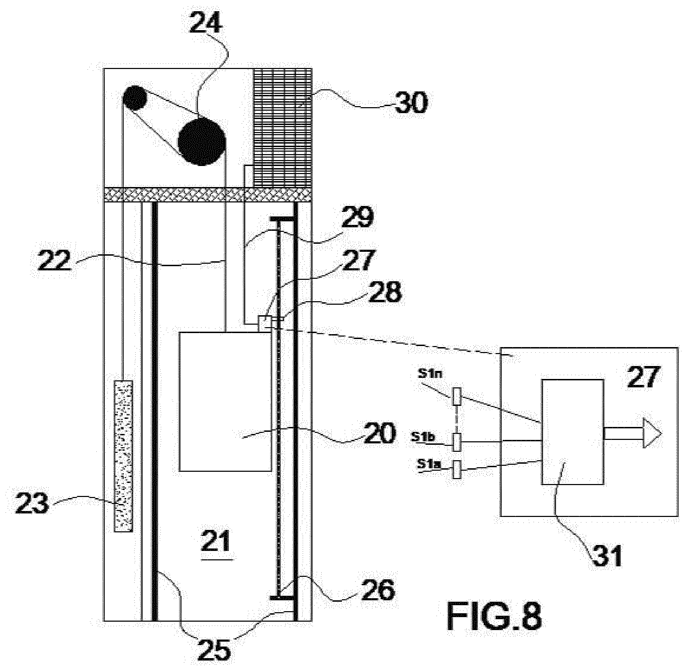

As shown in Figure 8, the lift cab 20 is known to be housed inside a well 21 of a building (not shown). For example, the cab 20 is moved by means of a cable mechanism 22 and counterweight 23 actuated by a suitable electric motor 24. Generally, the cab slides along a pair of rails 25 mounted in the well. Advantageously, according to the invention, the cab 20 is associated with a measuring system of its position comprising a reference fixed element 26 or wire rope running parallel to the rails 25 and an encoder 27 mounted on the cab 20 and slidably mounted also on said wire rope 26 by means of a sleeve 28. The wire rope 26, the encoder 27 and the sleeve 28 are those described above. Preferably, the encoder 27 is fixed on the roof of the cab 20 by means of conventional supports. Therefore, the cab 20 moves, pulling the encoder and the sleeve associated therewith along the wire rope 26 so that the encoder provides an absolute measurement of the position of the cab at every moment of its motion inside the well. The encoder 27 is then operatively connected via a suitable cable 29 to a conventional control unit 30 of a lift or elevator in order to receive the signals sent by the encoder 27. In particular, the encoder 27 is equipped with a microprocessor 31 able to receive impulses from the angular rotation sensors S1a, S1b, ...S1n, encoding them in numerical values and sending them to the control unit 30. The control unit then processes these values in a completely conventional way to control the position of the cab 20.

The advantage of applying the measuring system of the invention to a lift or elevator is based on the ease of installation of the reference element and the simplicity of the elements of which such system is comprised. This translates into less maintenance, longer system life and consequently considerably lower production costs compared to systems of the known art.

From that which has been described so far, it is clear that the system for measuring the positioning of a movable object with respect to a fixed reference according to the invention makes it possible to overcome the drawbacks highlighted previously. In effect, as demonstrated, all complex systems of the known art are greatly simplified due to a very simple structure that is easy to install.

The measuring system is highly versatile due to its structure and therefore exceeds the limits of previous systems.

The components that make it up are easy to manufacture and may be installed in any type of machinery such as machine tools for mechanical machining such as turning, milling, cutting, welding.

Particularly advantageous is the application to lifts and elevators, as explained above.

The measuring system of the present invention is thus subject to variations and modifications all within the capacity of the person skilled in the art, however without departing from the scope of protection as defined by the accompanying claims.

For example, the number of toothed wheels that transmit the rotation of the sleeve applied to the reference fixed element may vary according to specific needs or preferences, as well as their size, number and shape of the teeth.

Likewise, the electronic component, i.e. the microprocessor, of the encoder may be modified by the person skilled in the art in order to be adapted to the detection of the sensors, also through modifications of the program for processing the signals received therefrom. In particular, a so-called learning or calibration phase of the system may be necessary, as is usually the case.

As shown above, the encoders may also be incremental or absolute with detection systems of the position based on optical systems with disks associated with rotating elements equipped with windows or holes specially arranged to allow a light beam to pass through in a coded manner. These encoders may then be operatively connected to the reference element or wire rope via any one of the mechanical or magnetic systems described above.

## Claims

1. Lift or elevator (20) comprising a measuring system for measuring its position within a well (21) with respect to a fixed element, said system comprising an encoder (10;27) mounted on said lift or elevator and a reference element (6;26) fixed and substantially rectilinear, said fixed and substantially rectilinear element comprises an external surface which is cylindrical and helical or threaded, and said encoder is functionally connected to said fixed and substantially rectilinear element by means of a sleeve (100) which sleeve comprises an external surface complemental to said helical or threaded surface in order to allow the sliding along said element, and said sleeve comprising mechanical (4) and/or magnetic (17) means adapted to excite corresponding detecting means (18, 13, 16) through magnetic means (12, 15) of said encoder, **characterized in that** the sleeve (100) comprises a bipolar ring magnet (17) provided with a corresponding sensor (18), and said encoder (10) comprises a toothed wheel (11) which engages the circumferential toothed ring (4) of the sleeve (1), a magnet (12) and a corresponding sensor (13) being mounted onto a face of said toothed wheel on a rotation axis, onto the opposed face of the wheel being then axially mounted a reductive epicyclical system (14) and on said system, always axially, a corresponding magnet (15) and a sensor (16).

2. Lift or elevator (20) according to claim 1, wherein said fixed element (6) is a wire rope whose helical or threaded surface is made of wires stranded together.

3. Lift or elevator (20) according to claim 1 or 2, wherein said exciting magnetic means of the encoder is a magnetic ring (17) mounted onto said sleeve (100) with a corresponding Hall sensor (18).

4. Lift or elevator (20) according to any one of claims 1 to 3, wherein said sleeve (100) comprises a central body (2) in the form of a disk, provided with said circumferential toothed ring (4), and a couple of fastening ball bearings (5) fixed onto each of the opposed faces of said central body.

## Patentansprüche

1. Fahrstuhl oder Aufzug (20), der ein Messsystem zum Messen seiner Position innerhalb eines Schachtes (21) in Bezug auf ein stationäres Element umfasst, wobei das System einen Codierer (10; 27), der an dem Fahrstuhl oder Aufzug angebracht ist, sowie ein Bezugselement (6; 26) umfasst, das stationär und im Wesentlichen geradlinig ist, wobei das stationäre und im Wesentlichen geradlinige Element eine Außenfläche umfasst, die zylindrisch und spiralförmig oder schraubenförmig ist, und der Codierer mittels einer Hülse (100) funktional mit dem stationären und im Wesentlichen geradlinigen Element verbunden ist, wobei die Hülse eine Außenfläche umfasst, die komplementär zu der spiralförmigen oder schraubenförmigen Fläche ist, um das Gleiten an dem Element entlang zu ermöglichen, die Hülse eine mechanische Einrichtung (4) und/oder eine magnetische Einrichtung (17) umfasst, die so eingerichtet ist, dass sie über magnetische Einrichtungen (12, 15) des Codierers entsprechende Erfassungseinrichtungen (18, 13, 16) erregt, **dadurch gekennzeichnet, dass** die Hülse (100) einen bipolaren Ringmagneten (17) umfasst, der mit einem entsprechenden Sensor (18) versehen ist, und der Codierer (10) ein Zahnrad (11), das mit dem Umfangs-Zahnring (4) der Hülse (1) in Eingriff ist, einen Magneten (12) sowie einen entsprechenden Sensor (13) umfasst, der an einer Fläche des Zahnrades auf einer Drehachse angebracht ist, an der gegenüberliegenden Fläche des Rades ein untersetzendes epizyklisches System (14) axial angebracht und an dem System jeweils axial ein entsprechender Magnet (15) sowie ein Sensor (16) angebracht sind.

2. Fahrstuhl oder Aufzug (20) nach Anspruch 1, wobei das stationäre Element (6) ein Drahtseil ist, dessen spiralförmige oder schraubenförmige Fläche aus miteinander verseilten Drähten besteht.

3. Fahrstuhl oder Aufzug (20) nach Anspruch 1 oder 2, wobei die erregende magnetische Einrichtung des Codierers ein magnetischer Ring (17) ist, der mit einem entsprechenden Hall-Sensor (18) an der Hülse (100) angebracht ist.

4. Fahrstuhl oder Aufzug (20) nach einem der Ansprüche 1 bis 3, wobei die Hülse (100) einen mittigen Körper (2) in Form einer Scheibe, der mit dem Umfangs-Zahnring (4) versehen ist, sowie ein Paar fixierender Kugellager (5) umfasst, die an jeder der gegenüberliegenden Flächen des mittigen Körpers befestigt sind.

## Revendications

1. - Ascenseur ou élévateur (20) comprenant un système de mesure pour mesurer sa position à l'intérieur d'un puits (21) par rapport à un élément fixe, ledit système comprenant un codeur (10 ; 27) monté sur ledit ascenseur ou élévateur et un élément de référence (6 ; 26) fixe et sensiblement rectiligne, ledit élément fixe et sensiblement rectiligne comprenant une surface externe qui est cylindrique et hélicoïdale ou filetée, et ledit codeur étant relié de manière fonctionnelle audit élément fixe et sensiblement rectiligne au moyen d'un manchon (100), lequel manchon comprend une surface externe complémentaire de ladite surface hélicoïdale ou filetée afin de permettre le coulissement le long dudit élément, et ledit manchon comprenant des moyens mécaniques (4) et/ou magnétiques (17) conçus pour exciter des moyens de détection correspondants (18, 13, 16) par l'intermédiaire de moyens magnétiques (12, 15) dudit codeur, **caractérisé par le fait que** le manchon (100) comprend un aimant annulaire bipolaire (17) pourvu d'un capteur correspondant (18), et ledit codeur (10) comprend une roue dentée (11) qui est en prise avec l'anneau denté circonférentiel (4) du manchon (1), un aimant (12) et un capteur correspondant (13) étant montés sur une face de ladite roue dentée sur un axe de rotation, un système épicyclique réducteur (14) étant ensuite monté axialement sur la face opposée de la roue et un aimant correspondant (15) et un capteur (16) étant montés toujours axialement sur ledit système.

2. - Ascenseur ou élévateur (20) selon la revendication 1, dans lequel ledit élément fixe (6) est un câble métallique dont la surface hélicoïdale ou filetée est faite de fils torsadés ensemble.

3. - Ascenseur ou élévateur (20) selon la revendication 1 ou 2, dans lequel lesdits moyens magnétiques d'excitation du codeur sont un anneau magnétique (17) monté sur ledit manchon (100) avec un capteur à effet Hall (18) correspondant.

4. - Ascenseur ou élévateur (20) selon l'une quelconque des revendications 1 à 3, dans lequel ledit manchon (100) comprend un corps central (2) sous la forme d'un disque, pourvu dudit anneau denté circonférentiel (4), et deux roulements à billes de fixation (5) fixés sur chacune des faces opposées dudit corps central.
